# EUROPEAN PATENT SPECIFICATION

(11) **EP 1 629 539 B1**
(45) Date of publication and mention of the grant of the patent: **30.07.2008**
(21) Application number: 04733420.6
(22) Date of filing: 17.05.2004
(51) Int. Cl.: H01L 35/34

(54) **METHOD OF MANUFACTURING A THERMOELECTRIC DEVICE**
VERFAHREN ZUR HERSTELLUNG EINER THERMOELEKTRISCHEN VORRICHTUNG
PROCEDE DE FABRICATION D'UN DISPOSITIF THERMOELECTRIQUE

(30) Priority: 23.05.2003 EP 03101497
(43) Date of publication of application: 01.03.2006
(73) Proprietor: Koninklijke Philips Electronics N.V., 5621 BA Eindhoven (NL)
(72) Inventor: OUWERKERK, Martin, NL-5656 AA Eindhoven (NL); DEKKER, Ronald, NL-5656 AA Eindhoven (NL); MELLIER, Maxime, R., L., NL-5656 AA Eindhoven (NL); EGNER, Sebastian, NL-5656 AA Eindhoven (NL); LASANCE, Clemens, J., M., NL-5656 AA Eindhoven (NL)
(74) Representative: Eleveld, Koop Jan
(86) International application number: PCT/IB2004/050710
(87) International publication number: WO 2004/105146

(56) References cited:
- EP-A- 0 760 530
- EP-A- 0 805 501
- EP-A- 1 102 333
- WO-A-00/30185
- US-A- 3 981 751
- US-A- 5 022 928
- US-A- 5 167 723
- US-A1- 2003 057 525
- DEKKER R ET AL: "SUBSTRATE TRANSFER FOR RF TECHNOLOGIES" IEEE TRANSACTIONS ON ELECTRON DEVICES, IEEE INC. NEW YORK, US, vol. 50, no. 3, March 2003 (2003-03), pages 747-757, XP001163660 ISSN: 0018-9383
- DEKKER R ET AL: "Substrate transfer: enabling technology for RF applications" IEEE INTERNATIONAL ELECTRON DEVICES MEETING 2003 IEEE, 8 December 2003 (2003-12-08), pages 15.4.1-4, XP010684031 PISACATAWAY, NJ, USA ISBN: 0-7803-7872-5
- PATENT ABSTRACTS OF JAPAN vol. 2003, no. 09, 3 September 2003 (2003-09-03) & JP 2003 133600 A (KITAGAWA IND CO LTD; NATIONAL INSTITUTE OF ADVANCED INDUSTRIAL & TECHN), 9 May 2003 (2003-05-09)

## Description

The invention relates to a method of manufacturing a thermoelectric device comprising a flexible foil on which two groups of series-connected, strip-shaped parts are provided, where the materials chosen for the two groups of parts have a different thermoelectric coefficient, and said groups of parts are patterned such that the connections between a part of one group and another part of the other group are alternately situated each time in one of two areas of the foil which are situated at a distance from each other, and where, following the provision of the strip-shaped parts on a substrate, the foil is provided on the strip-shaped parts, after which the substrate is removed. A device obtained by means of such a method constitutes an attractive alternative to a battery power supply. In the case of such a device only a temperature difference present in the vicinity of the device is used to make the device operate as a generator. Replacing or recharging of the device via an electric network, such as the electric mains, is not necessary.

Such a method is known from the publication entitled "Micro fabrication of thermoelectric generators on flexible foil substrates as a power source for autonomous microsystems" by Wenmin Qu et. al., published in Journal of Micromechanics and Microengineering (abbreviated to J. Micromech. Microeng), 11 (2001) pp. 146-152. In said publication (see page 147, left-hand column) a description is given of how a 50 µm thick, flexible copper foil is provided, by means of electrodeposition, with groups of strip-shaped parts of antimony (Sb) and bismuth (Bi) in accordance with a pattern which is desirable for the use as a thermoelectric generator. Subsequently, the strip-shaped parts are spin coated with an epoxy film wherein the strip-shaped parts are embedded after curing of the epoxy film. Finally the flexible copper foil is removed by means of etching.

A drawback of the known device resides in that it is less suitable for the use of rigid substrates, such as a semiconductor substrate, instead of the copper foil. Such a semiconductor substrate is comparatively rigid as a result of its thickness, which is often in excess of 100 µm and frequently even above 500 µm. The use of a semiconductor substrate has the advantage that devices, of which one or more of the materials of the strip-shaped parts comprise a semiconductor material, can be formed more readily. Due to the comparatively large thickness of a semiconductor substrate, etching of said substrate is comparatively time-consuming, which is objectionable.

The object of the present invention therefore is to provide a method which is suitable for the use of a comparatively rigid and hence thick substrate, such as a semiconductor substrate, and which nevertheless enables a high speed.

To achieve this, in accordance with the invention, a method of the type mentioned in the opening paragraph is characterized in that for the substrate use is made of a rigid substrate, and prior to the removal of the rigid substrate, a rigid carrier plate is attached onto the foil, which rigid carrier plate is removed again from the flexible foil after the rigid substrate has been removed. The invention is first of all based on the recognition that by providing a rigid carrier plate on the foil before the substrate is removed, the device constantly remains rigid during the gradual removal of the substrate because of the presence of the rigid carrier plate. The invention is further based on the recognition that this enables the use of a grinding technique to remove the rigid substrate. As such a technique is much faster than a chemical etch technique, the substrate, or at least the greater part thereof, can be removed very rapidly. After the removal of the rigid substrate, the rigid carrier plate can be removed again, which results in a flexible (synthetic resin) foil which comprises the groups of strip-shaped parts and can serve as a thermoelectric generator. For the rigid carrier plate use can be made, for example, of a glass or quartz plate. The term rigid as used herein is to be taken to mean "unbendable or at least not easily bendable". Said term stands in opposition to the term flexible. Using the same material, this means that a rigid body will be substantially thicker than a flexible body (foil) of this material.

In a preferred embodiment of a method, at least the greater part of the rigid substrate is therefore removed by means of grinding. Preferably, a remaining, only comparatively thin part of the rigid substrate is removed solely by means of a chemical etch technique. In spite of this, the method in accordance with the invention remains very fast. In this preferred embodiment use is preferably made of a semiconductor substrate.

Preferably, the rigid carrier plate is attached to the foil by means of an adhesive layer, and after the removal of the substrate, the foil is removed by pulling it loose from the adhesive layer. Such a method is particularly simple and hence attractive. In this method use is made of the recognition that a suitable choice of the adhesive layer enables, on the one hand, the adhesion between adhesive layer, carrier plate and synthetic resin foil to be sufficiently strong to carry out the method in accordance with the invention, while, on the other hand, the adhesion between the adhesive layer and the foil is sufficiently small to remove the foil by pulling it loose from the carrier plate provided with the adhesive layer. An adhesive layer that proved to be particularly suitable for this purpose contains a 1,6 hexanedioldiacrylate. Using this adhesive layer in combination with a foil comprising a polyimide and a substrate of glass, good results were achieved.

As noted hereinabove, by using a semiconductor substrate it becomes easier to manufacture one or more of the groups of strip-shaped parts from a semiconductor material. A particular advantage of a method in accordance with the invention is that the strip-shaped parts can also be readily made of a monocrystalline semiconductor material instead of a polycrystalline semiconductor material. The thermoelectric coefficient of such a monocrystalline semiconductor material is comparatively high, while, on the other hand, the electric resistance may be sufficiently low. The devices thus obtained form suitable thermoelectric generators and, in addition, their manufacture is compatible with the manufacture of the other components of a device wherein the thermoelectric generator will be incorporated as a power supply because these components often comprise semiconductor components such as ICs (= Integrated Circuits). Besides, integration with such components is comparatively easy.

In an attractive modification of the method in accordance with the invention, for the substrate use is made of a monocrystalline silicon substrate which is provided with an isolating layer on which a polycrystalline silicon layer is deposited. For the isolating layer use may be made of a layer of silicon oxide or silicon nitride which may be formed by thermal oxidation or CVD (= Chemical Vapor Deposition). The polycrystalline silicon layer is deposited, for example, by means of CVD. This modification has the advantage that both the method and the device obtained are comparatively inexpensive.

In another, also favorable modification, a buried isolating layer is formed in a monocrystalline silicon substrate by means of an implantation of oxygen ions. The rigid substrate is then formed by the part of the silicon substrate situated below the buried layer, while the superjacent (monocrystalline!) part is used in the formation of the groups of strip-shaped parts. The (last part of the) rigid substrate can be readily removed by means of etching because the buried isolating layer forms a suitable etch-stop layer for, for example, an etchant base on KOH. The buried layer may also (electrically) isolate the strip-shaped parts. In addition, after the removal of the rigid substrate, the isolating layer still present at this stage may be used, if desirable, to carry out technological adaptations to the device.

Preferably, a number of the two series-connected groups of strip-shaped parts are arranged in parallel between two strip-shaped conductors which are formed on the foil. In this manner, the power suppliable by the device manufactured can be substantially increased, leading to greater applicability of the device. The pattern of the strip-shaped parts of the individual groups as well as the pattern of the parallel arrangement thereof are preferably chosen such that, after folding or coiling the foil in a certain way, the connections of all strip-shaped parts are alternately situated in two spaced apart parts or areas of the (folded or coiled) device. The device may thus be compact and can be readily brought into contact with an existing temperature gradient.

These and other aspects of the invention are apparent from and elucidated with reference to the embodiment(s) described hereinafter.
Fig. 1 is a diagrammatic, plan view of a thermoelectric device manufactured by means of a method in accordance with the invention,
Fig. 2 is a diagrammatic, cross-sectional view in the thickness direction and taken on the line II-II of the device shown in Fig. 1,
Figs. 3 through 10 are diagrammatic, cross-sectional views, at right angles to the thickness direction, of the device shown in Fig. 1 in successive stages of the manufacture by means of a first embodiment of a method in accordance with the invention,
Fig. 11 is a diagrammatic, plan view of a first modification of the device shown in Fig. 1,
Fig. 12 is a diagrammatic, perspective view of the device shown in Fig. 1, in a folded state,
Fig. 13 is a diagrammatic, plan view of a second modification of the device shown in Fig. 1, and
Fig. 14 is a diagrammatic, perspective view of the device shown in Fig. 13, in a coiled state.

The figures are not drawn to scale and some dimensions, such as dimensions in the thickness direction, are exaggerated for clarity. In the different Figures, corresponding areas or parts are represented using the same reference numeral or hatching, whenever possible.

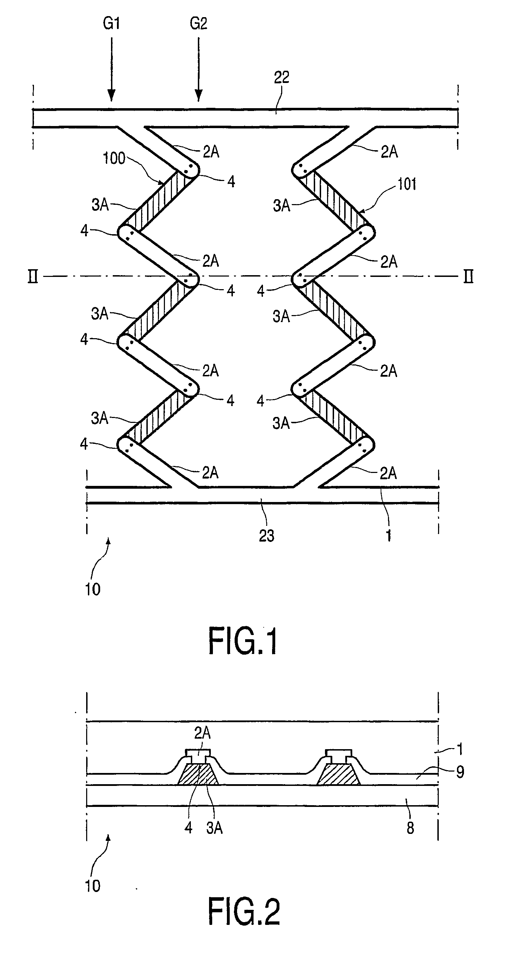

Fig. 1 is a diagrammatic, plan view of a thermoelectric device manufactured by means of a method in accordance with the invention, and Fig. 2 is a diagrammatic, cross-sectional view, in the thickness direction and taken on the line II-II, of the device shown in Fig. 1. A device 10 here comprises a flexible synthetic resin foil 1 which, in this case, is strip-shaped and in which two groups 2, 3 of strip-shaped parts 2A, 3A which are series-connected via connections 4, are embedded. The parts 2A comprise, in this case, aluminum strips and the parts 3 A comprise monocrystalline silicon. The zig-zag pattern 100 of the interconnected groups 2, 3 causes the connections 4 to be alternately situated in two spaced apart areas G1, G2 of the foil. By virtue thereof, the connections 4 can be readily introduced alternately into an area with a lower temperature and an area with a higher temperature, provided of course that such a temperature gradient is present. The strip-shaped semiconductor parts 3A are, in this case, further embedded between two isolating layers 8, 9 which, in this case, are made of silicon dioxide. The isolating layer 9 is provided with apertures in which the connections 4 between the silicon parts 3 A and the aluminum strips 2A are formed.

In this example, the device 10 comprises a plurality of zig-zag patterns 100, 101 only two of which are shown in the drawing, and which are arranged in parallel and connected to two strip-shaped conductors 22, 23 of aluminum which are situated near an outer edge of the foil 1. By virtue thereof, the capacitance of the thermoelectric generator 10 is substantially increased. The pattern 101 is mirrored with respect to the pattern 100 with a view to folding the device 10 of this example.

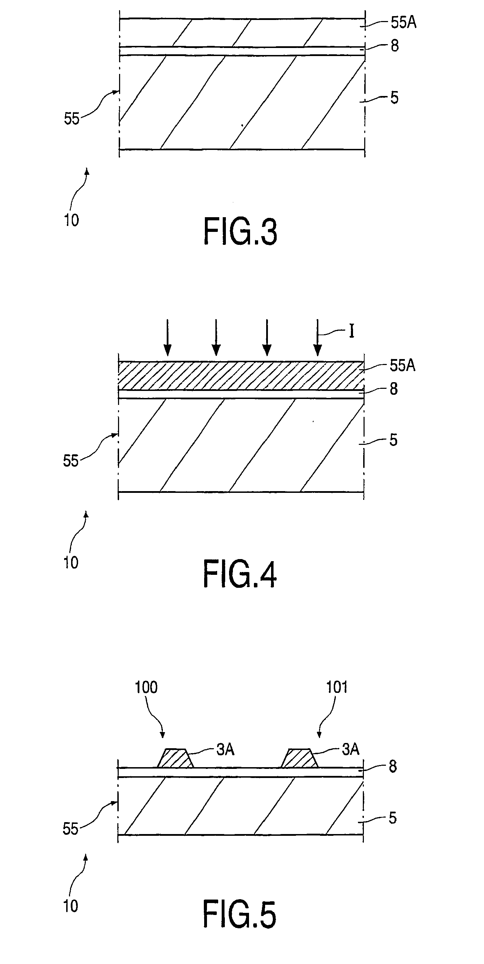

Figs. 3 through 10 are diagrammatic, cross-sectional views at right angles to the thickness direction of the device of Fig. 1 in successive stages of the manufacture by means of an embodiment of a method in accordance with the invention. The manufacture of the device 10 is based (see Fig. 3) on the use of a monocrystalline semiconductor substrate 55 having a resistivity of 20 Ωcm wherein a buried isolating layer 8 is formed by implantation of oxygen ions. The thickness of the regions 5, 8, 55A thus formed is, in this case, 650 µm, 0.4 µm and 0.2 µm, perspectively.

Next, (see Fig. 4) the part 55A of the silicon substrate 55 which is situated above the isolating layer 8 is heavily n-type doped by means of an ion implantation I of, in this case, arsenic ions. The flux of arsenic atoms is, for example, 10¹⁶ at/cm².

Subsequently, (see Fig. 5) the n-type-doped part is largely removed by means of photolithography and plasma etching, the strip-shaped parts 3 A being arranged in a chevron-shaped pattern that forms part of the zig-zag pattern to be formed of interconnected semiconductor strips 3A and aluminum strips that are still to be provided. In this example, for instance 1250 strips of silicon 3A are formed having a width of 5 µm and an interspacing of 3 µm. Unlike what is suggested in the drawing, the strips 3A here extend parallel to the edges of the foil. A true zig-zag configuration, as shown in the Figures, is also possible however. In Figs. 3 through 10, only the formation of two zig-zag patterns 100, 101 is shown, like in Fig. 1. The length of the strips 3 A in this case is approximately 1 mm and the thickness is approximately 0.2 µm. The overall width of a zig-zag is 1250 x 8 µm is 1 cm.

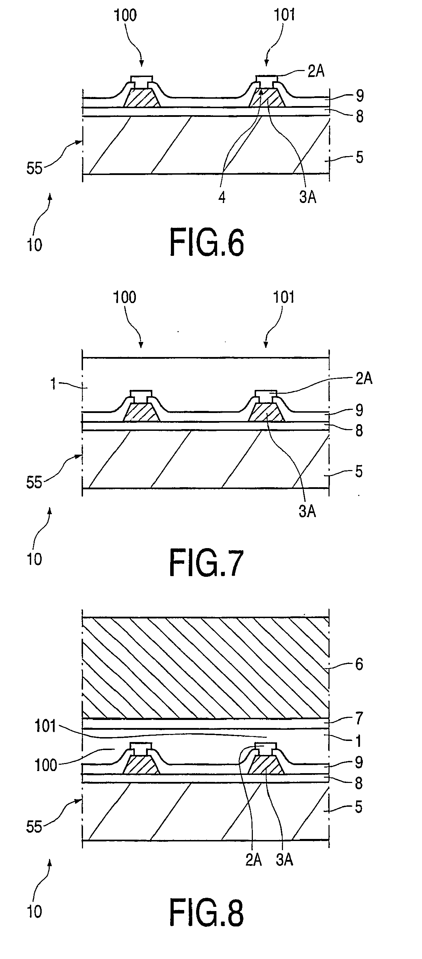

Next, a further isolating layer 9 of silicon dioxide is formed over the mesa-shaped strips 3A (see Fig. 6) by means of CVD. The thickness of this layer 9 in this case is 0.3 µm. Above the ends of the strips 3A, apertures of, for example, 2 µm x 2 µm are formed in the isolating layer 9 by means of photolithography and etching. Subsequently an, in this case, 0.7 µm thick aluminum layer is deposited, in this case by means of vapor deposition, over the device 10 to be formed. By means of photolithography and etching, this aluminum layer is formed into a chevron-shaped pattern of strips 2A which in conjunction with the chevron-shaped pattern of the semiconductor strips 3A forms the zig-zag structure of Fig. 1. The connections 4 between the aluminum strips 2A and the silicon strips 3A are then alternately situated in two spaced apart areas indicated by means of G1 and G2 in Fig. 1. If a temperature gradient that is present in, or applied to, the surroundings of the device 10 is presented across these areas, then the device 10 will act as a generator. Of course, in this example, the conductor tracks 22, 23 shown in Fig. 1 are formed at the same time from the aluminum layer. The patterns 100, 101 are thus incorporated in a parallel arrangement between these conductors 22, 23.

Subsequently, (see Fig. 7) a polyimide layer 1 is provided by means of spin coating in a thickness of in this example 10 µm, wherein, after curing, the patterns 100, 101 are embedded. The foil 1 thus comprises in this case a polyimide synthetic resin.

Next, (see Fig. 8) a rigid carrier plate 6, in this case a 340 µm thick glass plate 6, is attached to the foil 1 by means of an adhesive. The adhesive layer 7 comprises in this case a 10 µm thick layer of HDDA mentioned in the preamble.

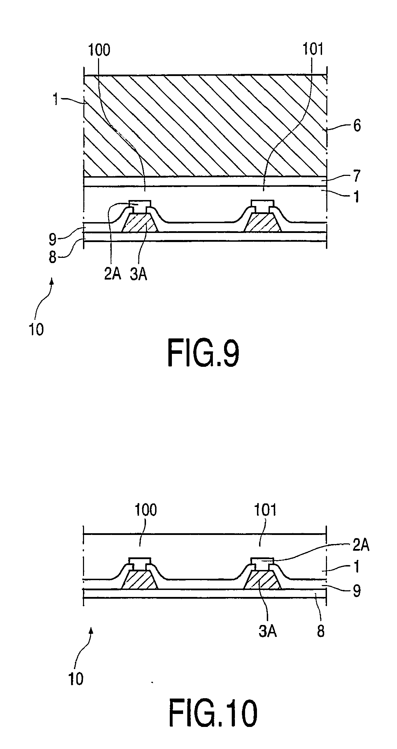

Subsequently, (see Fig. 9), the substrate part 5 is largely removed by means of grinding using a DISCO grinding machine. The device 10 to be formed is then situated in the grinding machine, not shown, in a mirrored orientation with respect to the adhesive layer 7, the substrate part 5 thus being situated on the upper side where the grinding process takes place. Approximately 600 µm of the substrate 5 are removed by grinding. The remaining 50 µm of the substrate part 5 are removed, in this case, by wet-chemical etching using an aqueous KOH solution, in which process the isolating layer 8 serves as an etch-stop layer.

Finally (see Fig. 10), the foil 1 is detached from the adhesive layer 7 near an edge of the glass plate 6 using for example a scalpel. Then the foil 1 is gripped and pulled in its entirety from the glass plate 6 provided with the adhesive layer 7 using tweezers or by hand. The device 10 is now ready for further treatments, such as coiling or folding, as will be illustrated hereinbelow.

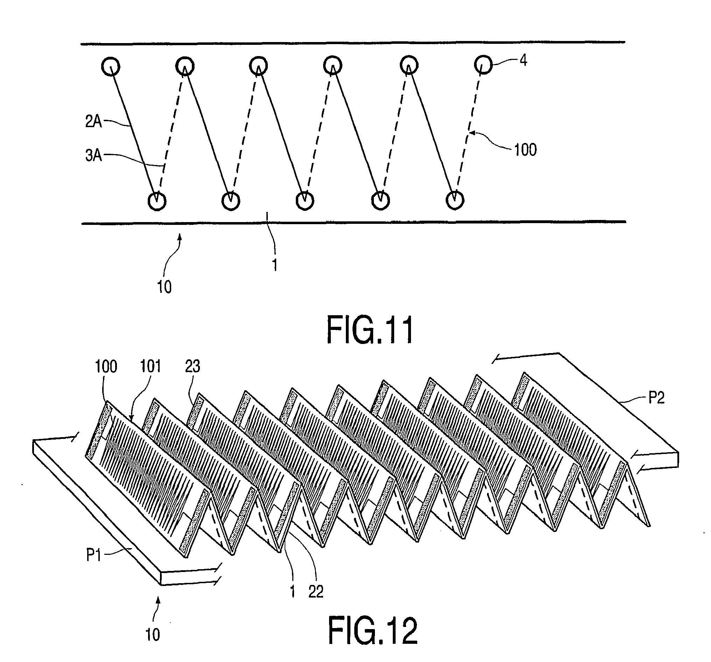

Fig. 11 diagrammatically shows a plan view and, in part, a phantom view of a first modification of the device shown in Fig. 1. The most important differences with the device of Fig. 1 and the associated manufacture thereof are the following: the foil used in this case is a prefabricated synthetic resin foil 1 provided with holes 4. On one side thereof, the semiconductor strips 3A, indicated by means of interrupted lines in Fig. 11, are formed as discussed with respect to Figs. 3 through 9. On the other side of the foil 1, the aluminum strips 2A are formed in the stage corresponding to Fig. 7, which strips are connected to the silicon strips 3A via the apertures 4 in the foil. In Fig. 11 only one zig-zag pattern 100 is shown.

Fig. 12 is a diagrammatic, perspective view of the device shown in Fig. 1, in a folded state. Using one or two toothed molds, the device of Fig. 1 can be folded as shown in Fig. 12. The molds are not shown in the drawing. To facilitate folding, either with or without the use of molds, the foil 1 may be provided, if necessary, with folding lines, not shown, which are situated between two neighboring patterns 100, 101. Next, thermally well-conducting plates P1, P2 of, for example, copper are provided on the bottom side and on the upper side, for example, by means of a thermally well-conducting adhesive. During operation of the device 10 these plates P1, P2, which are only partly shown in the drawing, are then introduced into a zone having, respectively, a high and a low(er) temperature. The power supplied by the device 10 may be drawn from external electric connection regions, not shown. In a further modification, not shown in the drawing, the folded foil is further folded around a hollow pipe and is in turn surrounded by a further hollow pipe. The latter may be exposed, for example, to a medium with a lower temperature, while a medium with a higher temperature is formed by the inner hollow pipe.

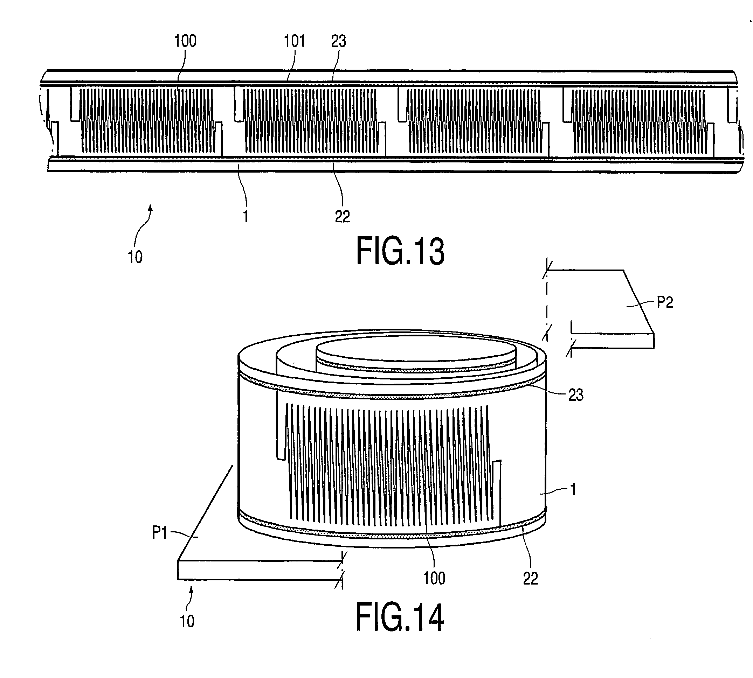

Fig. 13 is a diagrammatic, plan view of a second modification of the device of Fig. 1. Fig. 14 is a diagrammatic perspective view of the device shown in Fig. 13, in a coiled state. The only difference (see Fig. 13) with the device of Fig. 1 is that the zig-zag patterns 100, 101 have been rotated through 90 degrees with respect to the conductor tracks 22, 23 to which the patterns 100, 101 arranged in parallel are still connected. In the coiled state (see Fig. 14) two plates P1, P2 are again attached to the device 10.

The invention is not limited to the example described herein, and, within the scope of the invention, many variations and modifications are possible to those skilled in the art. For example, devices having a different geometry and/or different dimensions may be manufactured. Instead of a substrate of Si, use may alternatively be made of a substrate of glass, ceramic or a synthetic resin.

It is further noted that materials other than those mentioned in the examples may be used within the scope of the invention. Also other deposition techniques may be used for the materials mentioned or for other materials, such as sputtering. Instead of wet-chemical etching methods, use may alternatively be made of "dry" techniques, such as plasma etching, and conversely.

It is further noted that the device may comprise further active and passive semiconductor elements or electronic components, such as diodes and/or transistors and resistors and/or capacitors, whether or not in the form of an integrated circuit. Within the context of the invention, a diode and a capacitor enabling temporary power storage to be realized in a simple manner would be suitable in particular. The manufacture is of course efficiently adapted thereto.

## Claims

1. A method of manufacturing a thermoelectric device (10) comprising a flexible foil (1) on which two groups (2, 3) of series-connected, strip-shaped parts (2A, 3A) are provided, where the materials chosen for the two groups of parts (2A, 3A) have a different thermoelectric coefficient, and said groups of parts are patterned such that the connections (4) between a part (2A) of one group (2) and another part (3A) of the other group (3) are alternately situated each time in one of two areas (G1, G2) of the foil (1) which are situated at a distance from each other, and where, following the provision of the strip-shaped parts (2A, 3A) on a substrate (5), the foil (1) is provided on the strip-shaped parts (2A, 3A), after which the substrate (5) is removed, **characterized in that** for the substrate (5) use is made of a rigid substrate (5), and prior to the removal of the rigid substrate (5), a rigid carrier plate (6) is attached onto the foil (1), which rigid carrier plate is removed again from the flexible foil (1) after the rigid substrate (5) has been removed.

2. A method as claimed in claim 1, **characterized in that** at least the greater part of the rigid substrate (5) is removed by means of grinding.

3. A method as claimed in claim 1 or 2, **characterized in that** the carrier plate (6) is attached to the foil (1) by means of an adhesive layer (7), and after the removal of the substrate (5), the foil (1) is removed by pulling it loose from the adhesive layer (7).

4. A method as claimed in claim 3, **characterized in that** for the material of the adhesive layer (7), 1,6 hexanedioldiacrylate (HDDA) is used as the adhesive, and for the material of the foil (1) use is made of a polyimide.

5. A method as claimed in claim 1, 2, 3 or 4, **characterized in that** for the substrate (5) use is made of a semiconductor substrate (5).

6. A method as claimed in claim 1, 2, 3, 4 or 5, **characterized in that** for the material of at least one (3) of the groups (2, 3) of strip-shaped parts (3A) use is made of a semiconductor material.

7. A method as claimed in any one of the preceding claims, **characterized in that** for the substrate (5) use is made of a monocrystalline silicon substrate (5) which is provided with an isolating layer (8) on which a polycrystalline silicon layer (55A) is deposited.

8. A method as claimed in any one of claims 1 through 6, **characterized in that** the substrate (5) is formed by the part of a monocrystalline silicon substrate (55) in which a buried oxide layer (8) is formed by means of an implantation of oxygen atoms, and which is situated below the oxide layer (8).

9. A method as claimed in any one of the preceding claims, **characterized in that** a number of the two series-connected groups (2, 3) of strip-shaped parts (2A, 3A) are arranged in parallel between two strip-shaped conductors (22, 23) which are formed on the foil (1).

10. A method as claimed in claim 9, **characterized in that** the foil (1) is folded or coiled, said folding or coiling taking place in such a manner that the connections (4) of the two interconnected groups (2, 3) of strip-shaped parts (2A, 3A) remain in two spaced apart positions (P1, P2).

## Patentansprüche

1. Verfahren zum Herstellen einer thermoelektrischen Anordnung (10), die eine flexible Folie (1) umfasst, auf der zwei Gruppen (2, 3) von in Reihe miteinander verbundenen, streifenförmigen Teilen (2A, 3A) aufgebracht werden, wobei die für die zwei Gruppen von Teilen (2A, 3A) gewählten Materialien einen unterschiedlichen thermoelektrischen Koeffizienten haben und die genannten Gruppen von Teilen so strukturiert werden, dass die Verbindungen (4) zwischen einem Teil (2A) der einen Gruppe (2) und einem anderen Teil (3A) der anderen Gruppe (3) abwechselnd jedes Mal in einem von zwei auf Abstand voneinander liegenden Gebieten (G1, G2) der Folie (1) liegen, und wobei nach dem Aufbringen der streifenförmigen Teile (2A, 3A) auf einem Substrat (5) die Folie (1) auf den streifenförmigen Teilen (2A, 3A) aufgebracht wird, woraufhin das Substrat (5) entfernt wird, **dadurch gekennzeichnet, dass** für das Substrat (5) ein starres Substrat (5) genutzt wird und vor dem Entfernen des starren Substrats (5) eine starre Trägerplatte (6) an der Folie (1) befestigt wird, welche starre Trägerplatte wieder von der flexiblen Folie (1) entfernt wird, nachdem das starre Substrat (5) entfernt worden ist.

2. Verfahren nach Anspruch 1, **dadurch gekennzeichnet, dass** zumindest der größere Teil des starren Substrats (5) mittels Schleifen entfernt wird.

3. Verfahren nach Anspruch 1 oder 2, **dadurch gekennzeichnet, dass** die Trägerplatte (6) mit Hilfe einer Klebstoffschicht (7) an der Folie (1) befestigt wird und die Folie (1) nach dem Entfernen des Substrats (5) durch Abziehen der Folie von der Klebstoffschicht (7) entfernt wird.

4. Verfahren nach Anspruch 3, **dadurch gekennzeichnet, dass** für das Material der Klebstoffschicht (7), 1,6-Hexandioldiacrylat (HDDA) als Klebstoff genutzt wird und für das Material der Folie (1) ein Polyimid genutzt wird.

5. Verfahren nach Anspruch 1, 2, 3 oder 4, **dadurch gekennzeichnet, dass** für das Substrat (5) ein Halbleitersubstrat (5) genutzt wird.

6. Verfahren nach Anspruch 1, 2, 3, 4 oder 5, **dadurch gekennzeichnet, dass** für das Material zumindest einer (3) der Gruppen (2, 3) von streifenförmigen Teilen (3A) ein Halbleitermaterial genutzt wird.

7. Verfahren nach einem der vorhergehenden Ansprüche, **dadurch gekennzeichnet, dass** für das Substrat (5) ein monokristallines Siliciumsubstrat (5) genutzt wird, das mit einer isolierenden Schicht (8) versehen wird, auf der eine polykristalline Siliciumschicht (55A) deponiert wird.

8. Verfahren nach einem der Ansprüche 1 bis 6, **dadurch gekennzeichnet, dass** das Substrat (5) durch den Teil eines monokristallinen Siliciumsubstrats (55), in dem mit Hilfe einer Implantation von Sauerstoffatomen eine vergrabene Oxidschicht (8) gebildet wird, der unter der Oxidschicht (8) liegt, gebildet wird.

9. Verfahren nach einem der vorhergehenden Ansprüche, **dadurch gekennzeichnet, dass** eine Anzahl der zwei in Reihe miteinander verbundenen Gruppen (2, 3) von streifenförmigen Teilen (2A, 3A) parallel zwischen zwei streifenförmigen Leitern (22, 23) angeordnet wird, die auf der Folie (1) gebildet werden.

10. Verfahren nach Anspruch 9, **dadurch gekennzeichnet, dass** die Folie (1) gefaltet oder aufgewickelt wird, welches Falten oder Aufwickeln in einer solchen Weise erfolgt, dass die Verbindungen (4) der zwei miteinander verbundenen Gruppen (2, 3) von streifenförmigen Teilen (2A, 3A) in zwei auf Abstand voneinander liegenden Positionen (P1, P2) bleiben.

## Revendications

1. Procédé de fabrication d'un dispositif thermoélectrique (10) comprenant une feuille flexible (1) sur laquelle sont prévus deux groupes (2, 3) de parties en forme de bande montées en série (2A, 3A) où les matériaux qui sont optés pour les deux groupes de parties (2A, 3A) présentent un coefficient thermoélectrique différent et où lesdits groupes de parties sont mis en configuration de telle façon que les connexions (4) entre une partie (2A) d'un groupe (2) et une autre partie (3A) de l'autre groupe (3) se situent chaque fois alternativement dans une des deux zones (G1, G2) de la feuille (1) qui se situent l'une à une distance de l'autre et où, après l'application des parties en forme de bande (2A, 3A) sur le substrat (5), la feuille (1) est appliquée sur les parties en forme de bande (2A, 3A) après quoi le substrat (5) est enlevé, **caractérisé en ce que** pour le substrat (5) on fait usage d'un substrat rigide (5) et **en ce qu'**avant l'enlèvement du substrat rigide (5) une plaque de support rigide (6) est fixée sur la feuille (1), laquelle plaque de support rigide est enlevée à nouveau de la feuille flexible (1) après l'enlèvement du substrat rigide (5).

2. Procédé selon la revendication 1, **caractérisé en ce qu'**au moins la plus grande partie du substrat rigide (5) est enlevée par voie de doucissage.

3. Procédé selon la revendication 1 ou 2, **caractérisé en ce que** la plaque de support (6) est fixée à la feuille (1) au moyen d'une couche adhésive (7) et **en ce que**, après l'enlèvement du substrat (5), on enlève la feuille (1) en la détachant de la couche adhésive (7).

4. Procédé selon la revendication 3, **caractérisé en ce que** pour le matériau de la couche adhésive (7) on fait usage de 1,6 hexanedioldiacrylate (HDDA) en tant qu'adhésif et **en ce que** pour le matériau de la feuille (1) on fait usage d'un polyimide.

5. Procédé selon la revendication 1, 2, 3 ou 4, **caractérisé en ce que** pour le substrat (5) on fait usage d'un substrat semi-conducteur (5).

6. Procédé selon la revendication 1, 2, 3, 4 ou 5, **caractérisé en ce que** pour le matériau d'au moins un (3) des groupes (2, 3) de parties en forme de bande (3A) on fait usage d'un matériau semi-conducteur.

7. Procédé selon l'une quelconque des revendications précédentes 1 à 6, **caractérisé en ce que** pour le substrat (5) on fait usage d'un substrat (5) constitué de silicium monocristallin (5) qui est pourvu d'une couche isolante (8) sur laquelle est déposée une couche (55A) constituée de silicium polycristallin.

8. Procédé selon l'une quelconque des revendications précédentes 1 à 6, **caractérisé en ce que** le substrat (5) est formé par la partie d'un substrat (55) constitué de silicium monocristallin dans lequel une couche d'oxyde enterrée (8) est formée au moyen d'une implantation d'atomes d'oxygène et qui se situe au-dessous de la couche d'oxyde (8).

9. Procédé selon l'une quelconque des revendications précédentes 1 à 8, **caractérisé en ce qu'**un certain nombre des deux groupes montés en série (2, 3) de parties en forme de bande (2A, 3A) est agencé en parallèle entre deux conducteurs en forme de bande (22, 23) qui sont formés sur la feuille (1).

10. Procédé selon la revendication 9, **caractérisé en ce que** la feuille (1) est pliée ou enroulée, ledit pliage ou ledit enroulement se déroulant de telle façon que les connexions (4) des deux groupes interconnectés (2, 3) de parties en forme de bande (2A, 3A) restent dans deux positions (P1, P2) qui sont espacées l'une de l'autre.
